# EUROPÄISCHE PATENTSCHRIFT

(11) **EP 2 982 032 B1**
(45) Veröffentlichungstag und Bekanntmachung des Hinweises auf die Patenterteilung: **22.07.2020**
(21) Anmeldenummer: 14724666.4
(22) Anmeldetag: 05.05.2014
(51) Int. Cl.: H02M 7/00, H02K 11/00, H05K 7/20

(54) **STROMRICHTERANORDNUNG UND VERFAHREN ZUR HERSTELLUNG EINER STROMRICHTERANORDNUNG**
CURRENT CONVERTER ASSEMBLY AND METHOD FOR PRODUCING A CURRENT CONVERTER ASSEMBLY
AGENCEMENT DE CONVERTISSEUR DE COURANT ET PROCÉDÉ DE FABRICATION D'UN AGENCEMENT DE CONVERTISSEUR DE COURANT

(30) Priorität: 15.05.2013 EP 13167816
(43) Veröffentlichungstag der Anmeldung: 10.02.2016
(73) Patentinhaber: Rolls-Royce Deutschland Ltd & Co KG, 15827 Blankenfelde-Mahlow (DE)
(72) Erfinder: NEUMEISTER, Matthias, 90469 Nürnberg (DE); KASPAR, Michael, 85640 Putzbrunn (DE); KIEFL, Stefan, 80992 München (DE); KRIEGEL, Kai, 81739 München (DE); SEIDEL, Julian, 80339 München (DE); GEISLER, Stephan, 09439 Weißbach (DE); JARAUSCH, Wolfgang, 09114 Chemnitz (DE)
(86) Internationale Anmeldenummer: PCT/EP2014/059037
(87) Internationale Veröffentlichungsnummer: WO 2014/184020

(56) Entgegenhaltungen:
- US-A1- 2006 022 298
- US-A1- 2010 327 709

## Beschreibung

Die vorliegende Erfindung betrifft eine Stromrichteranordnung und ein Verfahren zur Herstellung einer Stromrichteranordnung.

Stromrichteranordnungen sind elektrische Schaltungsanordnungen, die eine elektrische Gleichspannung (DC) in eine Wechselspannung (AC) umwandeln (Wechselrichter) und/oder eine elektrische Wechselspannung in eine Gleichspannung konvertieren (Gleichrichter). Wechselrichter werden beispielsweise im Bereich der regenerativen Energiequellen verwendet, um eine von einer Photovoltaik oder ähnlichem erzeugte Gleichspannung in ein Wechselspannungsnetz einzuspeisen. Außerdem werden solche Wechselrichter beispielsweise auch für batteriegespeiste Notstromversorgungen benötigt, die die von der Batterie bereitgestellte Gleichspannung in eine Wechselspannung umwandeln, um die Wechselspannung in das Notstromnetz einzuspeisen. Darüber hinaus finden Gleichrichter beispielsweise beim Laden einer Batterie oder einer Batterieanordnung Verwendung, die von einer Wechselspannungsquelle gespeist wird. Insbesondere bei Elektrofahrzeugen werden darüber hinaus auch Kombinationen von Gleichrichtern und Wechselrichtern eingesetzt. Während des Fahrbetriebs wird beispielsweise eine von einer Batterie bereitgestellte Gleichspannung in eine gesteuerte Wechselspannung umgewandelt, um einen elektrischen Antrieb anzusteuern. Während des Bremsbetriebs arbeitet der elektrische Antrieb dann als Generator und erzeugt eine Wechselspannung, die nach dem Gleichrichten durch eine Stromrichterschaltung zum Aufladen der Batterie verwendet werden kann.

Bei heutigen Stromrichtern werden Leistungsmodule verwendet, bei denen die Leistungshalbleiterchips flächig auf einem Substrat, in der Regel aus Keramik, angeordnet sind. Die Leiterbahnen zum Anschluss dieser Halbleiterchips sind somit naturgemäß ebenfalls flächig angeordnet. Die Leiterbahnanordnung ist dabei auf zwei Dimensionen beschränkt. Bei dieser zweidimensionalen Anordnung ergeben sich zum Teil relativ lange Stromwege. Zusätzlich umschließen Hin- und Rückleiter zum Teil relativ große Flächen. Aufgrund dieser beiden Effekte erhöht sich im Betrieb die Streuinduktivität einer solchen Stromrichteranordnung. Dies wirkt sich negativ auf das Schaltverhalten der Leistungshalbleiter aus. Die verwendeten Leistungshalbleiter, wie beispielsweise Dioden oder IGBT (Insulated Gate Bipolar Transistor), haben in diesen Fällen höhere Schaltverluste und erhitzen sich somit stark. Daher muss in diesem Fall der Kühlkreislauf entsprechend groß dimensioniert werden. Die Leistung eines solchen Stromrichters ist daher weniger von den verwendeten Halbleiterchips, sondern vielmehr von der zur Verfügung stehenden Kühlung abhängig. Je besser die Kühlung des Stromrichters, desto höher die mögliche Leistung.

Aus der US 2010/327709 A1 ist ein Aufbau bekannt, bei dem Halbleiterbauelemente auf den Außenseiten von im wesentlichen trapezförmigen Kühlkörpern angeordnet sind.

Es besteht daher ein Bedarf nach einer effizient kühlbaren Schaltungsanordnung mit verbessertem Schaltverhalten.

Gemäß einem Aspekt schafft die vorliegende Erfindung eine Stromrichteranordnung mit einer dreidimensionalen Trägeranordnung, die senkrecht zu einer Raumrichtung einen trapezförmigen Querschnitt aufweist; und einer Mehrzahl von Schaltelementen, wobei die Mehrzahl von Schaltelementen auf zwei gegenüberliegenden Seitenflächen der Trägeranordnung angeordnet sind.

Gemäß einem weiteren Aspekt schafft die vorliegende Erfindung ein Verfahren zur Herstellung einer Stromrichteranordnung mit den Schritten des Bereitstellens einer dreidimensionalen Trägeranordnung, die senkrecht zu einer Raumrichtung einen trapezförmigen Querschnitt aufweist; und des Anordnens einer Mehrzahl von Schaltelementen auf der Trägeranordnung, wobei die Mehrzahl von Schaltelementen auf zwei gegenüberliegenden Seitenflächen der Trägeranordnung angeordnet werden.

Es ist eine Idee der vorliegenden Erfindung, alle erforderlichen Bauelemente für eine Stromrichteranordnung auf einem dreidimensionalen Träger so anzuordnen, dass eine effiziente Nutzung aller Außenseiten dieses Trägers realisiert wird. Bei konventionellen zweidimensionalen Anordnungen steht nur eine Oberseite und eine Unterseite des zweidimensionalen Trägers für die Aufnahme von zur Verfügung. Da für die erforderliche Kühlung hierbei normalerweise auf einer der beiden Seiten ein Kühlelement angebracht werden muss, steht bei konventionellen Stromrichteranordnungen nur eine Seite für die Aufnahme von Bauelementen zur Verfügung. Im Gegensatz hierzu ergeben sich aufgrund der dreidimensionalen Ausgestaltung des Trägers mehrere zur Verfügung stehende Außenseiten, die alle für eine Aufnahme von Bauelementen der Stromrichteranordnung genutzt werden können.

Ein wesentlicher Vorteil dieser dreidimensionalen Stromrichteranordnung besteht darin, dass eine erfindungsgemäße Trägeranordnung auch gleichzeitig als Kühlelement dient. Somit können die Schaltelemente, die erforderliche Steuerelektronik und die Stromführungen effizient gekühlt werden.

Ein weiterer Vorteil besteht darin, dass durch die erfindungsgemäße dreidimensionale Anordnung der räumliche Abstand zwischen der Steuerelektronik und den Anschlüssen der Leistungselektronik sehr gering ist. Somit können zwischen Steuerelektronik und Leistungselektronik sehr geringe Leitungswege realisiert werden. Dies führt zu entsprechend geringen Leitungsinduktivitäten, was sich wiederum positiv auf das Schaltverhalten und die entstehenden Schaltverluste der Stromrichteranordnung auswirkt.

Ebenfalls vorteilhaft ist, dass sich auch die leistungstragenden Anschlüsse der Stromrichteranordnung mittels sehr kurzer Stromwege realisieren lassen. Insbesondere kann durch die dreidimensionale Ausgestaltung der Stromrichteranordnung ein erforderlicher Zwischenkreiskondensator sehr dicht an die Halbleiterschaltelemente herangeführt werden.

Gemäß einer Ausführungsform umfasst jedes der Mehrzahl der Schaltelemente einen Halbleiterschalter und/oder eine Diode. Halbleiterschalter, wie beispielsweise IGBT oder MOSFET, insbesondere im Zusammenschluss mit Dioden haben sich für solche Stromrichteranordnungen gut bewährt.

Gemäß der Erfindung ist die Mehrzahl von Schaltelementen auf den Außenseiten der Trägeranordnung angeordnet. Die Schaltelemente weisen somit von der Trägeranordnung weg. Daher sind keine weiteren Schutzmaßnahmen wie beispielsweise eine zusätzliche Isolierung der Schaltelemente erforderlich.

Gemäß einer weiteren Ausführungsform ist die Trägeranordnung im Inneren hohl, vorzugsweise ist das Innere der Trägeranordnung dabei von einer Kühlflüssigkeit durchströmt. Durch eine so ausgestaltete Trägeranordnung, insbesondere eine flüssigkeitsgekühlte Trägeranordnung, ist eine besonders effiziente Kühlung der Stromrichteranordnung möglich. Dies wiederum führt zu einer besonders leistungsfähigen Stromrichteranordnung.

Gemäß noch einer weiteren Ausführungsform sind die Schaltelemente auf einer Oberfläche eines Substrats angeordnet, wobei die der dieser Oberfläche des Substrats gegenüberliegende Unterseite des Substrats auf einem Kühlelement angeordnet ist. Auf diese Weise kann die Wärmeenergie der Schaltelemente besonders effizient an die Trägeranordnung zur Kühlung abgegeben werden.

Erfindungsgemäß umfasst die Stromrichteranordnung ferner eine Steuervorrichtung, die dazu ausgelegt ist, die Mehrzahl von Schaltelementen anzusteuern, wobei die Steuervorrichtung auf einer weiteren Seite der Trägeranordnung angeordnet ist und die weitere Seite der Trägeranordnung die beiden Seiten der Trägeranordnung mit der Mehrzahl der Schaltelemente verbindet. Durch das Anordnen der Steuervorrichtung zwischen den Schaltelementen kann eine Verbindung der Steuervorrichtung mit den Schaltelementen durch besonders kurze und niederinduktive Leitungswege realisiert werden. Dies wirkt sich sehr gut auf das Schaltverhalten und die entstehenden Schaltverluste der Stromrichteranordnung aus.

In einer weiteren Ausführungsform umfasst die Stromrichteranordnung ferner eine Anschlussvorrichtung, die dazu ausgelegt ist, Gleichspannungs- und/oder Wechselspannungsanschlüsse bereitzustellen, wobei die Anschlussvorrichtung auf einer Seite der Trägeranordnung angeordnet ist, die beiden Seiten der Trägeranordnung mit der Mehrzahl der Schaltelemente verbindet. Vorzugsweis liegt diese Seite mit der Anschlussvorrichtung gegenüber der Seite mit der Steuervorrichtung. Auf diese Weise können auch die Leistungsanschlüsse der Stromrichteranordnung besonders kurz ausgeführt werden.

In einer weiteren Ausführungsform umfasst die Stromrichteranordnung ferner eine Kondensatoranordnung, die mit der Anschlussvorrichtung verbunden ist. Auf diese Weise kann die Kondensatoranordnung, beispielsweise ein Zwischenkreiskondensator einer Stromrichteranordnung, sehr dicht an die Schaltelemente herangeführt werden. Dies wirkt sich vorteilhaft auf das Schaltverhalten der Stromrichtervorrichtung aus.

Gemäß einer speziellen Ausführungsform ist die Mehrzahl von Schaltelementen über Federkontakte mit der Steuervorrichtung und/oder der Stromrichtervorrichtung verbunden. Die Verwendung von Federkontakten zum Anschluss der Steuervorrichtung bzw. der Anschlussvorrichtung ermöglicht eine besonders einfache und schnelle Kontaktierung der einzelnen Bauelemente.

Weitere Vorteile und Ausführungsformen der vorliegenden Erfindung ergeben sich aus der nachfolgenden Beschreibung im Zusammenhang mit den beigefügten Zeichnungen.

Dabei zeigen:
- Figur 1: eine perspektivische Darstellung einer Schrägansicht einer Trägeranordnung gemäß einer Ausführungsform der vorliegenden Erfindung;
- Figur 2: eine schematische Darstellung eines Querschnitts durch eine Trägeranordnung gemäß einer weiteren Ausführungsform der vorliegenden Erfindung;
- Figur 3: eine schematische Darstellung eines Querschnitts durch eine Trägeranordnung gemäß einer weiteren Ausführungsform der vorliegenden Erfindung;
- Figur 4: eine schematische Darstellung einer Draufsicht auf eine Stromrichteranordnung gemäß einer weiteren Ausführungsform der vorliegenden Erfindung;
- Figur 5: eine schematische Darstellung eines Querschnitts durch eine Stromrichteranordnung gemäß einer weiteren Ausführungsform der vorliegenden Erfindung;
- Figur 6: eine schematische Darstellung eines Herstellungsverfahrens für einer Stromrichteranordnung, wie es einer weiteren Ausführungsform der vorliegenden Erfindung zugrunde liegt; und
- Figur 7: eine detaillierte schematische Darstellung eines Herstellungsverfahrens für eine Stromrichteranordnung, wie es einer weiteren Ausführungsform der vorliegenden Erfindung zugrunde liegt.

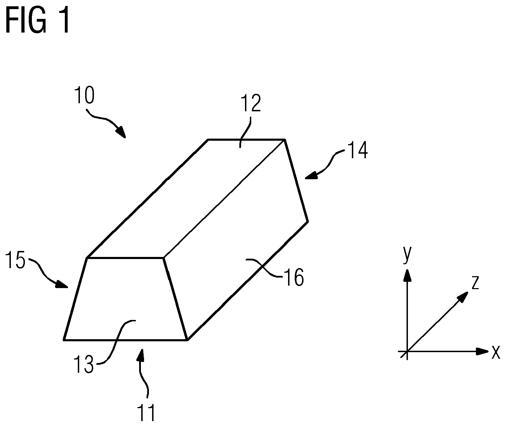

Figur 1 zeigt eine Schrägansicht einer Trägervorrichtung 10 für eine erfindungsgemäße Stromrichtervorrichtung. Die äußere Form dieser Trägervorrichtung 10 entspricht in etwa einem Prisma mit parallelen Ober- und Unterseiten, die in der x-z-Ebene liegen. Die Oberseite 12 und die Unterseite 11 haben dabei vorzugsweise die Form eines Rechtecks. Dabei sind die Kanten, die parallel zur z-Achse verlaufen, vorzugsweise gleich lang, während die Außenkanten, die parallel zu der x-Achse verlaufen, auf der Oberseite 12 vorzugsweise kürzer sind als auf der Unterseite 11. Somit ergibt sich für die Vorderseite 13 und die Rückseite 14 der Trägervorrichtung 10 die Form eines gleichschenkeligen Trapezes. Die Vorderseite 13 und die Rückseite 14 liegen dabei vorzugsweise parallel zu der x-y-Ebene. Es ist jedoch auch denkbar, dass die Vorderseite 13 und die Rückseite 14 zumindest geringfügig gegenüber dieser x-y-Ebene geneigt sind. Schließlich weist die Trägervorrichtung 10 weiterhin zwei Seitenflächen 15 und 16 auf, die jeweils die Unterseite 11 mit der Oberseite 12 verbinden.

Die Trägervorrichtung 10 ist dabei im Inneren vorzugsweise hohl. Auf diese Weise kann das Innere der Trägervorrichtung 10 von einer Kühlflüssigkeit durchströmt werden. Somit ist eine effiziente Kühlung der Stromrichtervorrichtung möglich. Alternativ ist es auch möglich, dass die Trägervorrichtung 10 einen oder mehrere Kühlkanäle im Inneren aufweist, die von einer Kühlflüssigkeit zur Kühlung der Stromrichteranordnung durchflossen werden können. Diese Kühlkanäle können beispielsweise eine mäanderförmige oder labyrinthförmige Struktur aufweisen. Durch das Kühlen mittels einer Kühlflüssigkeit ist eine besonders effiziente Kühlung möglich. Darüber hinaus ist es jedoch auch denkbar, dass das Innere der Trägervorrichtung 10 durch ein Gas, beispielsweise Luft oder ähnliches, gekühlt wird.

Die Außenseite der Trägervorrichtung 10, insbesondere die Unterseite 11, die Oberseite 12 und die beiden Seitenflächen 15 und 16 sind dabei vorzugsweise als geschlossene Flächen ausgeführt, so dass an diesen Seiten keine Kühlflüssigkeit austreten kann. Die Außenflächen können jedoch auch über entsprechende Öffnungen (nicht dargestellt) verfügen, die es ermöglichen, Kühlrippen der auf der Trägeranordnung 10 angebrachten Bauelemente in das Innere der Trägervorrichtung hineinragen zu lassen. Auf diese Weise können die Kühlrippen besonders gut gekühlt werden. In diesem Fall ist jedoch auf einen dichten Abschluss der Öffnungen während des Betriebs zu achten.

An der Vorderseite 13 und/oder der Rückseite 14 können darüber hinaus Öffnungen zum Eintritt bzw. Austritt einer Kühlflüssigkeit angeordnet sein (nicht dargestellt). Diese Öffnungen zum Ein- bzw. Austritt der Kühlflüssigkeit können jedoch auch entsprechend den Erfordernissen auf einer anderen Seite der Trägervorrichtung 10 angebracht werden. Weiterhin kann die Trägervorrichtung 10 auch über geeignete Befestigungsvorrichtung (nicht dargestellt) verfügen, die es ermöglichen, die weiteren Bauelemente der Stromrichtervorrichtung an der Trägervorrichtung 10 zu befestigen und dabei gegebenenfalls auch eine geeignete elektrische Kontaktierung zwischen den einzelnen Bauelementen zu ermöglichen.

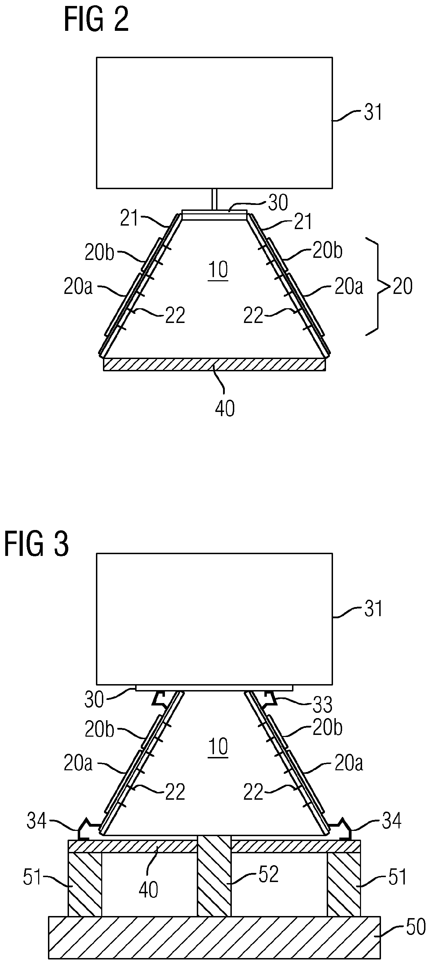

Figur 2 zeigt einen Querschnitt durch eine Trägervorrichtung 10 entlang der x-y-Ebene, senkrecht zur z-Achse. Die Trägervorrichtung 10 weist bei einem solchen Schnitt durch die x-y-Ebene in einen trapezförmigen Querschnitt auf. Die Unterseite 11 und die Oberseite 12 bilden dabei die beiden parallelen Seiten des Trapezes, während durch die beiden Seitenflächen 15 und 16 die Schenkel des Trapezes gebildet werden. Vorzugsweise handelt es sich dabei um ein gleichschenkeliges Trapez, das heißt, die beiden Schenkel des Trapez sind gleich lang. Eine Trägervorrichtung 10 mit einem solchen trapezförmigen Querschnitt, ist für die Anordnung der Bauelemente der Stromrichtervorrichtung besonders vorteilhaft. Grundsätzlich ist es jedoch auch denkbar, dass die Vorrichtung 10 einen von einem gleichschenkeligen Trapez abweichenden Querschnitt aufweist.

Auf den beiden Seitenflächen 15 oder 16 in Figur 2, die den beiden Schenkeln des Trapezes entsprechen, sind jeweils ein oder mehrere Schaltelemente 20 angeordnet. Vorzugsweise sind solche Schaltelemente 20 auf beiden Außenseiten 15 und 16 der Trägervorrichtung 10 angeordnet. Somit ergibt sich eine besonders gleichmäßige thermische Verteilung während des Betriebs der Stromrichteranordnung. Auch wenn bei einer gleichmäßigen symmetrischen Verteilung der Schaltelemente 20 auf den beiden Außenseite 15 und 16 der Trägeranordnung eine besonders gleichmäßige und vorteilhafte Verteilung erreicht werden kann, so ist es für spezielle Anwendungsfälle auch denkbar, die Schaltelemente 20 nur auf einer beiden Außenseiten 15 und 16 anzuordnen, oder die Schaltelemente 20 auf einer der beiden Außenseiten 15 und 16 mehr Schaltelemente 20 anzuordnen als auf der gegenüber liegenden Seitenfläche.

Jedes der Schaltelemente 20 weist dabei vorzugsweise ein Halbleiterschaltelement 20a sowie eine Diode 20b. Das Halbleiterschaltelement 20a ist dabei vorzugsweise ein bipolarer Transistor mit isoliertem Gate (IGBT) oder ein MOSFET. Andere Arten von Schaltelementen, insbesondere Halbleiterelementen, sind jedoch ebenso möglich. Die darüber hinaus zusätzlich angebrachte Diode 20b dient dabei vorzugsweise als Freilaufdiode.

Die Schaltelemente 20 sind dabei vorzugsweise auf einem Trägersubstrat 21 angeordnet, das neben den Halbleiterschaltelementen 20a und den Dioden 20b auch entsprechende Leiterbahnen zum Anschluss der Bauelemente aufweist. Vorzugsweise ist das Substrat 21 mit den Schaltelementen 20 dabei so auf der Trägervorrichtung 10 angeordnet, dass die Schaltelemente 20 von der Trägervorrichtung weg weisen. Somit dient das Substrat 21 gleichzeitig als Isolationsmedium zwischen den Schaltelementen 20 und der Trägervorrichtung 10. Da die Schaltelemente 20 somit isoliert auf der Trägervorrichtung 10 angeordnet sind, ist keine zusätzliche Isolierung auf der von der Trägervorrichtung 10 weg weisenden Seite erforderlich.

Für eine bessere Wärmeabfuhr der thermischen Energie, die während des Betriebs der Stromrichteranordnung in den Schaltelementen 20 entsteht, kann auf der Unterseite des Substrats 21 ein Kühlelement 22 angebracht werden. Dieses Kühlelement kann beispielsweise eine Struktur mit einer großen Oberfläche, wie zum Beispiel Kühlrippen aufweisen, die eine besonders gute Wärmeabgabe ermöglicht. Dabei werden die Schaltelemente 20 mit den Kühlelementen 22 so auf der Trägervorrichtung 10 angeordnet, dass die Kühlelemente 22 in das Innere der Trägervorrichtung 10 hineinragen. Während des Betriebs wird dabei das Kühlelement 22 von der Kühlflüssigkeit im Inneren der Trägervorrichtung 10umströmt und gekühlt. Auf diese Weise ist eine besonders gute Abfuhr der entstehenden thermischen Energie möglich, wodurch Leistungsfähigkeit der Stromrichteranordnung gesteigert werden kann.

Für den Anschluss der Schaltelemente 20 und die Verbindung der Schaltelemente 20 mit den weiteren Bauelementen der Stromrichtervorrichtung sind zahlreiche bekannte und zum Teil innovative Verbindungstechniken möglich. So können die Schaltelemente 20 beispielsweise mittels eines herkömmlichen Draht-Bond-Verbindungsverfahrens kontaktiert werden. Alternativ ist auch eine Verbindung mittels SiPLIT-Technologie (Siemens Planar Interconnect Technology) möglich. Darüber hinaus sind auch alle weiteren bekannten Verbindungstechnologien möglich, beispielsweise Schraubverbindungen, Kontaktierungen mittels Feder-Kontakten 33 etc.

Auf der Unterseite 11 der Trägervorrichtung 10 ist die Steuerelektronik 40 zur Ansteuerung der Schaltelemente 20 angeordnet. Die Steuerelektronik 40 ist dabei so auf der Unterseite 11 der Trägervorrichtung 10 angeordnet, dass einerseits zwischen Steuerelektronik 40 und der Vorrichtung 10 ein thermischer Kontakt entsteht und andererseits die Steuerelektronik 40 elektrisch isoliert von der Trägervorrichtung 10 ist. Auf diese Weise kann auch die thermische Energie der Steuerelektronik 40, die während des Betriebs der Stromrichtervorrichtung entsteht, durch die Trägervorrichtung 10 abgeführt werden. Die Außenseiten der Steuerelektronik 40 befinden sich dabei in unmittelbarer Nähe der Außenseiten der Schaltelemente 20. Somit sind die Verbindungswege zwischen Steuerelektronik 40 und Schaltelementen 20 besonders kurz. Es entstehen nur daher sehr geringe Leitungsinduktivitäten. Daher können die Schaltelemente 20 durch die Steuerelektronik 40 bei der erfindungsgemäßen Anordnung besonders präzise angesteuert werden. Das präzise, schnelle Schaltverhalten führt darüber hinaus auch zu reduzierten Schaltverlusten und somit auch zu einer geringeren thermischen Belastung der Stromrichteranordnung.

Im Weiteren befindet sich auf der Oberseite 12 der Trägervorrichtung 10, die der Unterseite 11 der Steuervorrichtung 40 gegenüberliegt, eine Anschlussvorrichtung 30 zur Kontaktierung der Schaltelemente 20 mit den Lastanschlüssen. Die Anschlussvorrichtung 30 dient einerseits zum Anschluss der Wechselspannungsanschlüsse und andererseits auch zum Anschluss der Gleichspannungsanschlüsse. Die Anschlussvorrichtung 30 ist dabei vorzugsweise als mehrlagige Verschienung ausgeführt, wie sie weiter unten näher beschrieben wird.

Ferner ist diese Anschlussvorrichtung 30 auch mit einer Kondensatorvorrichtung 31 verbunden. Beispielsweise kann es sich bei der Kondensatorvorrichtung 31 um einen oder mehrere Zwischenkreiskondensatoren handeln, wie sie bei Stromvorrichtervorrichtungen üblicherweise eingesetzt werden. Aufgrund der dreidimensionalen Anordnung der Bauelemente rund um die Trägervorrichtung 10 kann hierbei die Kondensatorvorrichtung 31 sehr dicht an die Schaltelemente 20 herangeführt werden. Somit ergeben sich zwischen der Kondensatorvorrichtung 31 und den Schaltelementen 20 nur sehr kurze Leitungswege mit entsprechend geringen Leitungsinduktivitäten. Dies wirkt sich ebenfalls vorteilhaft auf den Betrieb der erfindungsgemäßen Stromrichtervorrichtung aus.

Weiterhin ist die Anschlussvorrichtung 30 auch so auf der Trägervorrichtung 10 angeordnet, dass die Wärme der Anschlussvorrichtung 30 durch die Trägervorrichtung 10 gut abgeführt werden kann. Durch diese Kühlung der Anschlussvorrichtung 30 ist es möglich, die Anschlussvorrichtung 30 gegebenenfalls auch kleiner zu dimensionieren, ohne dass eine erhöhte thermische Belastung der stromführenden Lastanschlüsse entsteht.

Figur 3 zeigt einen Querschnitt durch eine Trägervorrichtung 10 und weitere Bauelemente einer erfindungsgemäßen Stromrichteranordnung. Auch in diesem Fall sind auf den beiden Außenseiten 15 und 16 der Trägervorrichtung 10 jeweils ein oder mehrere Schaltelemente angeordnet. Auf der Oberseite 12 ist auch hier eine Anschlussvorrichtung 30 mit Kondensatorvorrichtung 31 angeordnet. Auf der Unterseite 11 der Trägervorrichtung 10 ist die Steuervorrichtung 40 angeordnet. Die Steuervorrichtung 40 wird durch ein oder mehrere Halteelemente 51 gehalten. Weiterhin wird die Trägervorrichtung 10 ebenfalls durch ein oder mehrere Halteelemente 52 gehalten. Die Halteelemente 51 zur Halterung der Steuervorrichtung 40, sowie die Halteelemente 52 zur Halterung der Trägervorrichtung 10 werden dabei vorzugsweise durch eine gemeinsame Grundplatte 50, beispielsweise eine Gehäusewand oder ähnliches, gehalten. Somit entsteht zwischen den Halteelementen 51 für die Steuervorrichtung und den Halteelementen 52 für die Trägervorrichtung ein Zwischenraum, der ausreichend Platz für die Bauelemente der Steuervorrichtung 40 bietet.

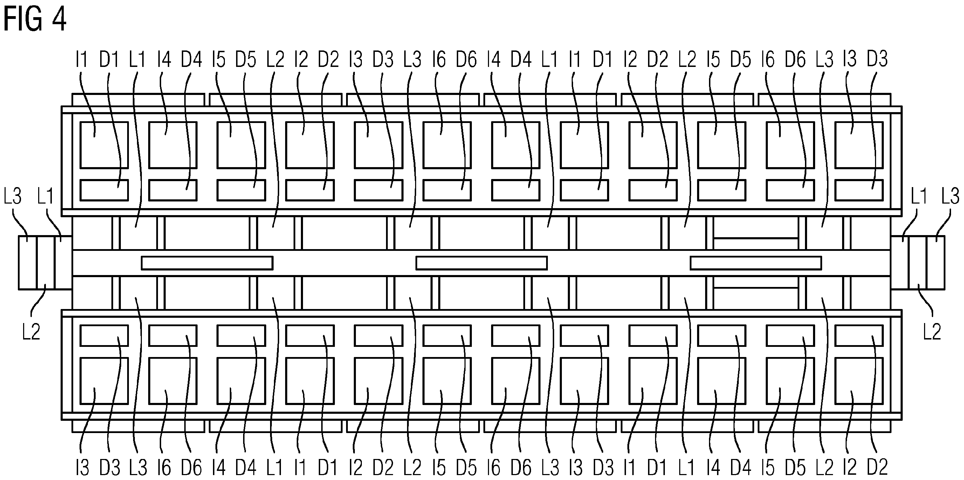

Figur 4 zeigt eine Draufsicht auf eine erfindungsgemäße Stromrichtervorrichtung, bei einer Draufsicht von oben auf die x-z-Ebene. In der Darstellung in Figur 4 ist dabei auf der linken und/oder rechten Außenseite jeweils ein Lastanschluss 32 angeordnet, durch den die Anschlussvorrichtung 30 mit einem externen Wechselspannungsanschluss verbunden werden kann. Durch diese Lastanschlüsse 32 kann somit die erfindungsgemäße Stromrichtervorrichtung beispielsweise mit einem externen Wechselspannungsnetz, einem Wechselspannungsverbraucher oder einer Wechselspannungsquelle verbunden werden. Vorzugsweise werden dabei auf beiden Seiten jeweils alle Phasenanschlüsse zum Anschluss der Wechselspannung herausgeführt. Alternativ ist es auch möglich, den Wechselspannungsanschluss nur auf einer Seite herauszuführen, oder die einzelnen Phasen auf unterschiedlichen Seiten herauszuführen. Grundsätzlich ist es darüber hinaus auch denkbar, bei Bedarf die Gleichspannungsanschlüsse der Stromrichtervorrichtung ebenfalls an den Lastanschlüssen 32 seitlich herauszuführen. Beispielsweise können auf der einen Seite, zum Beispiel links, die Wechselspannungsanschlüsse herausgeführt werden und auf der anderen Seite, beispielsweise rechts, die Gleichspannungsanschlüsse herausgeführt werden. Andere Variationen zum Herausführen der Lastanschlüsse sind ebenso möglich.

Vorzugsweise erfolgen jedoch die Gleichspannungsanschlüsse der erfindungsgemäßen Stromrichteranordnung unmittelbar an der Kondensatorvorrichtung 31, also an den entsprechenden Zwischenkreiskondensatoren.

Von oben bzw. unten zur Bildmitte hinein gesehen sind dabei in Figur 4 folgende Komponenten dargestellt: Im äußeren Bereich, also ganz oben und ganz unten sind die Steueranschlüsse für die Schaltelemente angeordnet. Daran schließen sich die entsprechenden Halbleiterschalter I1 bis I6 an. Hierdurch ergeben sich besonders kurze Leitungsführungen für die Steuerung der jeweiligen Schaltelemente. Im weiteren Verlauf von unten/oben zur Bildmitte hin schließen sich die entsprechenden Dioden D1 bis D6 an. Daraufhin folgen die Anschlussbereiche zur Kontaktierung der Schaltelemente 20 an der der Anschlussvorrichtung 30. Im zentralen mittleren Bereich ist schließlich die Anschlussvorrichtung 30 angeordnet. Dabei sind die Anschlusspunkte der Schaltelemente zur Kontaktierung an der Anschlussvorrichtung 30 so angeordnet, dass sich zwischen Schaltelementen und Anschlusspunkten möglichst geringe Leitungswege ergeben. In Figur 4 sind daher die Halbleiterschalter I1 und I4, sowie die Dioden D1 und D4 sehr nahe an dem Anschlusspunkt für den Leiter L1, die Halbleiterschalter I2 und I5, sowie die Dioden D2 und D5 sehr nahe an dem Anschlusspunkt für den Leiter L2, und die Halbleiterschalter I3 und I6, sowie die Dioden D3 und D6 sind sehr nahe an dem Anschlusspunkt für den Leiter L3. Für eine gleichmäßigere thermische Belastung sind darüber hinaus Schaltelemente und die Anschlusspunkte der jeweiligen Phasen der Wechselspannung auf den beiden Seiten der Trägervorrichtung 10 gegeneinander versetzt angeordnet.

Die Verbindung zwischen den Schaltelementen 20 und der Verbindungsvorrichtung 30 erfolgt dabei beispielsweise durch eine konventionelle Bond-Verbindungstechnik, durch geeignete Schraubverbindungen oder gegebenenfalls auch durch Kontaktierung mittels Federelemente 33. Besonders vorteilhaft hat sich in diesem Zusammenhang beispielsweise auch die bereits zuvor erwähnte SiPLIP-Technologie erwiesen. Federelemente ermöglichen dabei eine besonders einfache und rasche Montage und Kontaktierung. Allerding sind Federelemente aufgrund der eher geringen Kontaktfläche im Bereich der Federn vorzugsweise für eher geringe Stromstärken geeignet. Die Kontaktierung der Steueranschlüsse der Schaltelemente 20 mit der Steuervorrichtung 40 erfolgt analog die entsprechende Kontaktelemente 34.

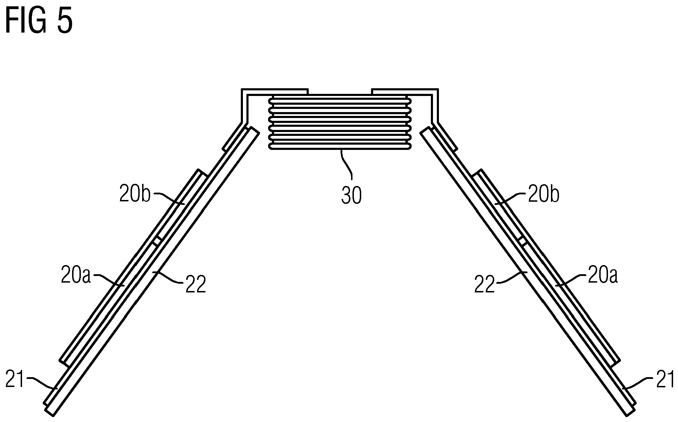

Figur 5 zeigt einen Querschnitt durch eine Verbindungsvorrichtung 30 und an die Verbindungsvorrichtung 30 angeschlossene Halbleiterelemente 20. Die Verbindungsvorrichtung 30 ist dabei als mehrlagige Verschienung ausgeführt. Eine solche Verschienung besteht aus einer Mehrzahl von stromtragenden metallischen Schienen, die untereinander durch elektrisch isolierende Abstandshalter getrennt sind. Im dargestellten Beispiel weist die Verbindungsvorrichtung 30 dabei von unten nach oben gesehen zunächst mehrere stromführende Lagen für die Anschlüsse der Wechselspannung auf. Diese Lagen sind dabei jeweils durch ein geeignetes Isolationsmedium voneinander getrennt. Darüber schließen sich, ebenfalls durch Isolationsmedien getrennt, stromführende Lagen für die Gleichspannung an. Auf diese Weise kann eine sehr kompakte Bereitstellung aller erforderlichen Leistungsanschlüsse erfolgen. Eine stromführende Lage, die an einem Anschlusspunkt mit einem Schaltelementen 20 verbunden werden soll, wird dabei mittels geeigneter Durchkontaktierung (nicht dargestellt) nach oben geführt und über geeignete Kontaktelemente mit den Schaltelementen 20 verbunden.

Die Schaltelemente 20, die beispielsweise aus Halbleiterschaltelementen 20a und Diode 20b bestehen, sind dabei auf einem isolierenden Trägermaterial 21 angeordnet. Beispielsweise kann es sich dabei um ein keramisches Trägermaterial handeln. Dieses Trägermaterial wird dabei zur Abführung der entstehenden Wärme vorzugsweise auf einem weiteren Kühlkörper 22 angeordnet. Zur besseren thermischen Kontaktierung kann dabei zwischen Substrat 21 und Kühlkörper 22 eine nicht dargestellte Wärmeleitpaste oder ähnliches eingebracht werden.

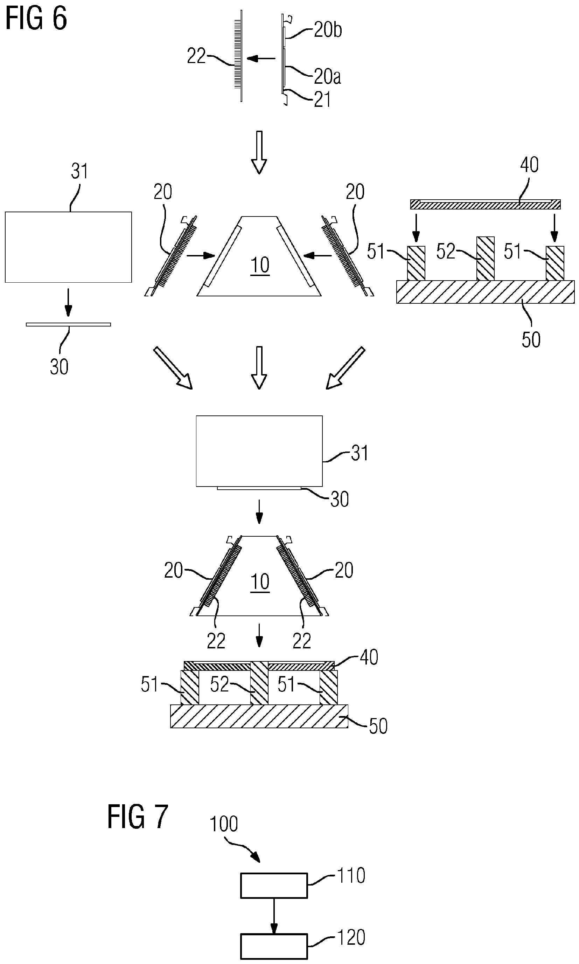

Figur 6 zeigt eine schematische Darstellung eines Verfahrens zur Herstellung einer Stromrichtervorrichtung gemäß einer Ausführungsform der vorliegenden Erfindung. Dabei wird zunächst in einem ersten Schritt 110 eine dreidimensionale Trägervorrichtung 10 bereitgestellt, die senkrecht zu einer Raumrichtung Z einen trapezförmigen Querschnitt aufweist. Daraufhin wird in Schritt 120 eine Mehrzahl von Schaltelementen 20 auf der Trägeranordnung 10 angeordnet, wobei die Mehrzahl von Schaltelementen 20 auf zwei gegenüberliegenden Seiten 15 und 16 der Trägeranordnung 10 angeordnet werden.

Das Herstellungsverfahren für eine erfindungsgemäße Stromrichtervorrichtung ist in Figur 7 nochmals detailliert dargestellt. Im oberen Bereich dieser Figur wird ein Schaltelement 20 aus Halbleiterschalter 20a und Diode 20b zunächst mit einem Kühlelement 22 verbunden. In der darunter dargestellten Ebene werden, wie in der Mitte dargestellt, die vorkonfigurierten Schaltelemente 20 mit den Kühlelementen auf der Trägervorrichtung 10 angeordnet. Die Trägervorrichtung 10 weist hierfür links und rechts jeweils geeignete Aussparungen auf, in denen die Kühlelemente 22 der Schaltelemente 20 eingebracht werden können. Ferner wird eine Kondensatorvorrichtung 31 mit einer Anschlussvorrichtung 30 verbunden (links dargestellt) und eine Steuervorrichtung 30 wird auf eine geeigneten Haltevorrichtung 51 aufgebracht (rechts dargestellt). Wie im unteren Bereich dargestellt, wird abschließend die Trägervorrichtung 10 mit den Schaltelementen 20 auf der Haltevorrichtung 52 aufgebracht und die Anschlussvorrichtung 30 mit der Kondensatorvorrichtung 30 wird ebenfalls mit der Trägervorrichtung 10 verbunden. Schließlich werden Schaltelemente 20 einerseits mit der Steuervorrichtung 40 und andererseits mit der Anschlussvorrichtung 30 elektrisch verbunden.

Zusammenfassend betrifft die vorliegende Erfindung eine dreidimensionale Anordnung für eine Stromrichtervorrichtung, wie beispielsweise einen Wechselrichter oder einen Gleichrichter. Hierzu werden auf einer Trägervorrichtung sowohl die erforderlichen Schaltelemente, als auch die Ansteuerelektronik und die Lastanschlüsse so angeordnet, dass besonders kurze Leitungswege entstehen. Alle erforderlichen Komponenten, wie Schaltelemente, Steuerelektronik und Lastanschlüsse sind auf einer gemeinsamen Trägervorrichtung angeordnet. Diese Trägervorrichtung dient gleichzeitig auch als Kühlvorrichtung für die komplette Schaltvorrichtung. Hierdurch wird ein besonders effizienter Betrieb der Stromrichtervorrichtung erzielt.

## Patentansprüche

1. Stromrichteranordnung, mit
einer dreidimensionalen Trägeranordnung (10), die senkrecht zu einer Raumrichtung (Z) einen trapezförmigen Querschnitt aufweist; und
einer Mehrzahl von Schaltelementen (20), wobei die Mehrzahl von Schaltelementen (20) auf zwei gegenüberliegenden Seitenflächen (15, 16) auf den Außenseiten der Trägeranordnung (10) angeordnet sind,
einer Steuervorrichtung (40), die dazu ausgelegt ist, die Mehrzahl von Schaltelementen (20) anzusteuern,
**dadurch gekennzeichnet, dass** die Steuervorrichtung (40) auf einer weiteren Seitenfläche (12) der Trägeranordnung (10) angeordnet ist, wobei die weitere Seitenfläche (12) der Trägeranordnung (10) die beiden gegenüberliegenden Seitenflächen (15, 16) der Trägeranordnung (10) mit der Mehrzahl der Schaltelemente (20) verbindet.

2. Stromrichteranordnung nach Anspruch 1, wobei jedes der Mehrzahl von Schaltelementen (20) einen Halbleiterschalter (20a) und/oder eine Diode (20b) umfasst.

3. Stromrichteranordnung nach einem der vorherigen Ansprüche, wobei die Trägeranordnung (10) im Inneren hohl ist.

4. Stromrichteranordnung nach Anspruch 3, wobei die Trägeranordnung im Inneren von einer Kühlflüssigkeit durchströmt wird.

5. Stromrichteranordnung nach einem der vorherigen Ansprüche, wobei die Schaltelemente (20) auf einer Oberfläche eines Substrats (21) angeordnet sind und eine der Oberseite des Substrats (21) gegenüber liegende Unterseite auf einem Kühlelement (22) angeordnet ist.

6. Stromrichteranordnung nach einem der vorherigen Ansprüche, ferner umfassend eine Anschlussvorrichtung (30), die dazu ausgelegt ist, Gleichspannungs- und / oder Wechselspannungsanschlüsse bereitzustellen und die auf einer Seite (11) der Trägeranordnung (10) angeordnet ist, die die beiden Seiten (15, 16) der Trägeranordnung (10) mit der Mehrzahl der Schaltelemente (20) verbindet.

7. Stromrichteranordnung nach Anspruch 6, ferner umfassend eine Kondensatoranordnung (31), die mit der Anschlussvorrichtung (30) verbunden ist.

8. Stromrichteranordnung nach einem der vorherigen Ansprüche, wobei die Mehrzahl von Schaltelementen (20) über Federkontakte mit der Steuervorrichtung (40) und/oder der Anschlussvorrichtung (30) verbunden sind.

9. Verfahren (100) zur Herstellung einer Stromrichteranordnung, mit den Schritten
Bereitstellen (110) einer dreidimensionalen Trägeranordnung (10), die senkrecht zu einer Raumrichtung (Z) einen trapezförmigen Querschnitt aufweist; und
Anordnen (120) einer Mehrzahl von Schaltelementen (20) auf der Trägeranordnung (10), wobei die Mehrzahl von Schaltelementen (20) auf zwei gegenüberliegenden Seitenflächen (15, 16) auf den Außenseiten der Trägeranordnung (10) angeordnet werden,
Anordnen einer Steuervorrichtung (40), die dazu ausgelegt ist, die Mehrzahl von Schaltelementen (20) anzusteuern, auf der Trägeranordnung (10),
**dadurch gekennzeichnet,**
**dass** die Steuervorrichtung (40) auf einer weiteren Seitenfläche (12) der Trägeranordnung (10) angeordnet wird, wobei die weitere Seitenfläche (12) der Trägeranordnung (10) die beiden gegenüberliegenden Seitenflächen (15, 16) der Trägeranordnung (10) mit der Mehrzahl der Schaltelemente (20) verbindet.

## Claims

1. Power converter arrangement having
a three-dimensional carrier arrangement (10) which has a trapezoidal cross section perpendicular to a spatial direction (Z); and
a plurality of switching elements (20), wherein the plurality of switching elements (20) are arranged on two opposite side surfaces (15, 16) on the outer sides of the carrier arrangement (10),
a control apparatus (40) which is designed to control the plurality of switching elements (20),
**characterized in that** the control apparatus (40) is arranged on a further side surface (12) of the carrier arrangement (10), wherein the further side surface (12) of the carrier arrangement (10) connects the two opposite side surfaces (15, 16) of the carrier arrangement (10) to the plurality of switching elements (20).

2. Power converter arrangement according to Claim 1, wherein each of the plurality of switching elements (20) comprises a semiconductor switch (20a) and/or a diode (20b) .

3. Power converter arrangement according to one of the preceding claims, wherein the carrier arrangement (10) is hollow in the interior.

4. Power converter arrangement according to Claim 3, wherein a cooling liquid flows through the interior of the carrier arrangement.

5. Power converter arrangement according to one of the preceding claims, wherein the switching elements (20) are arranged on a surface of a substrate (21), and an underside opposite the top side of the substrate (21) is arranged on a cooling element (22).

6. Power converter arrangement according to one of the preceding claims, also comprising a connection apparatus (30) which is designed to provide DC voltage and/or AC voltage connections and which is arranged on a side (11) of the carrier arrangement (10) which connects the two sides (15, 16) of the carrier arrangement (10) to the plurality of switching elements (20).

7. Power converter arrangement according to Claim 6, also comprising a capacitor arrangement (31) which is connected to the connection apparatus (30).

8. Power converter arrangement according to one of the preceding claims, wherein the plurality of switching elements (20) are connected to the control apparatus (40) and/or to the connection apparatus (30) via spring contacts.

9. Method (100) for producing a power converter arrangement, having the steps of
providing (110) a three-dimensional carrier arrangement (10) which has a trapezoidal cross section perpendicular to a spatial direction (Z); and
arranging (120) a plurality of switching elements (20) on the carrier arrangement (10), wherein the plurality of switching elements (20) are arranged on two opposite side surfaces (15, 16) on the outer sides of the carrier arrangement (10),
arranging a control apparatus (40), which is designed to control the plurality of switching elements (20), on the carrier arrangement (10),
**characterized**
**in that** the control apparatus (40) is arranged on a further side surface (12) of the carrier arrangement (10), wherein the further side surface (12) of the carrier arrangement (10) connects the two opposite side surfaces (15, 16) of the carrier arrangement (10) to the plurality of switching elements (20).

## Revendications

1. Arrangement convertisseur statique, comprenant un arrangement porteur (10) tridimensionnel qui possède une section transversale de forme trapézoïdale perpendiculairement à une direction dans l'espace (Z) ; et
une pluralité d'éléments de commutation (20), la pluralité d'éléments de commutation (20) étant disposés sur deux surfaces latérales (15, 16) opposées sur les côtés extérieurs de l'arrangement porteur (10),
un dispositif de commande (40) qui est conçu pour commander la pluralité d'éléments de commutation (20), **caractérisé en ce que** le dispositif de commande (40) est disposé sur une surface latérale supplémentaire (12) de l'arrangement porteur (10), la surface latérale supplémentaire (12) de l'arrangement porteur (10) reliant les deux surfaces latérales (15, 16) opposées de l'arrangement porteur (10) avec la pluralité d'éléments de commutation (20) .

2. Arrangement convertisseur statique selon la revendication 1, chacun de la pluralité d'éléments de commutation (20) comportant un commutateur semiconducteur (20a) et/ou une diode (20b).

3. Arrangement convertisseur statique selon l'une des revendications précédentes, l'arrangement porteur (10) étant creux à l'intérieur.

4. Arrangement convertisseur statique selon la revendication 3, l'arrangement porteur étant traversé à l'intérieur par un courant de liquide de refroidissement.

5. Arrangement convertisseur statique selon l'une des revendications précédentes, les éléments de commutation (20) étant disposés sur une surface d'un substrat (21) et un côté inférieur qui se trouve à l'opposé du côté supérieur du substrat (21) étant disposé sur un élément de refroidissement (22).

6. Arrangement convertisseur statique selon l'une des revendications précédentes, comprenant en outre un dispositif de raccordement (30) qui est conçu pour fournir des bornes de tension continue et/ou de tension alternative et qui est disposé sur un côté (11) de l'arrangement porteur (10) qui relie les deux côtés (15, 16) de l'arrangement porteur (10) avec la pluralité d'éléments de commutation (20).

7. Arrangement convertisseur statique selon la revendication 6, comprenant en outre un arrangement de condensateur (31) qui est relié au dispositif de raccordement (30).

8. Arrangement convertisseur statique selon l'une des revendications précédentes, la pluralité d'éléments de commutation (20) étant reliés au dispositif de commande (40) et/ou au dispositif de raccordement (30) par le biais de contacts à ressort.

9. Procédé (100) de fabrication d'un arrangement convertisseur statique, comprenant les étapes suivantes fourniture (110) d'un arrangement porteur (10) tridimensionnel qui possède une section transversale de forme trapézoïdale perpendiculairement à une direction dans l'espace (Z) ; et
disposition (120) d'une pluralité d'éléments de commutation (20) sur l'arrangement porteur (10), la pluralité d'éléments de commutation (20) étant disposés sur deux surfaces latérales (15, 16) opposées sur les côtés extérieurs de l'arrangement porteur (10), disposition, sur l'arrangement porteur (10), d'un dispositif de commande (40) qui est conçu pour commander la pluralité d'éléments de commutation (20), **caractérisé en ce**
**que** le dispositif de commande (40) est disposé sur une surface latérale supplémentaire (12) de l'arrangement porteur (10), la surface latérale supplémentaire (12) de l'arrangement porteur (10) reliant les deux surfaces latérales (15, 16) opposées de l'arrangement porteur (10) avec la pluralité d'éléments de commutation (20).
